# EUROPÄISCHE PATENTSCHRIFT

(11) **EP 1 386 218 B1**
(45) Veröffentlichungstag und Bekanntmachung des Hinweises auf die Patenterteilung: **22.12.2004**
(21) Anmeldenummer: 02732380.7
(22) Anmeldetag: 08.04.2002
(51) Int. Cl.: G06F 1/08

(54) **FREQUENZREGELSCHALTUNG**
FREQUENCY CONTROL CIRCUIT
CIRCUIT DE REGULATION DE FREQUENCE

(30) Priorität: 04.05.2001 DE 10121821
(43) Veröffentlichungstag der Anmeldung: 04.02.2004
(73) Patentinhaber: Infineon Technologies AG, 81669 München (DE)
(72) Erfinder: SEDLAK, Holger, 85658 Egmating (DE); KNIFFLER, Oliver, 81737 München (DE); WEDER, Uwe, 84072 Au/Hallertau (DE); GUO, Shuwei, 81737 München (DE)
(74) Vertreter: Epping Hermann & Fischer
(86) Internationale Anmeldenummer: PCT/DE2002/001283
(87) Internationale Veröffentlichungsnummer: WO 2002/091576

(56) Entgegenhaltungen:
- US-A- 5 974 557
- PATENT ABSTRACTS OF JAPAN vol. 1998, no. 14, 31. Dezember 1998 (1998-12-31) & JP 10 240373 A (MATSUSHITA ELECTRIC IND CO LTD), 11. September 1998 (1998-09-11)
- MOORE B D: "Tradeoffs in selecting IC temperature sensors" MICROPROCESSORS AND MICROSYSTEMS, IPC BUSINESS PRESS LTD. LONDON, GB, Bd. 23, Nr. 4, 11. Oktober 1999 (1999-10-11), Seiten 181-184, XP004184039 ISSN: 0141-9331

## Beschreibung

Die Erfindung betrifft eine Frequenzregelschaltung für Schaltungsanordnungen.

Bei Schaltungsanordnungen hängt der Stromverbrauch häufig davon ab, welche Funktionen durch die Schaltungsanordnung gerade ausgeführt werden. Bei digitalen Schaltungen wird beispielsweise für eine Multiplikation wesentlich mehr Strom benötigt als für eine einfache Addition. Zu beachten ist hierbei, daß ein hoher Stromverbrauch eine Erwärmung der digitalen Schaltung zur Folge hat und daher darauf geachtet werden muß, daß die Schaltungsanordnung bei Durchführung bestimmter Funktionen nicht zu heiß wird. Der Stromverbrauch ist dabei zudem proportional zur Taktfrequenz, mit der die Schaltungsanordnung arbeitet. Je höher die Taktfrequenz ist, desto höher ist natürlich auch der Stromverbrauch.

Zur Vermeidung einer zu starken Erwärmung der Schaltungsanordnung ist es daher bekannt, die Funktion der Schaltungsanordnung mit dem höchsten Stromverbrauch zu ermitteln und sodann bei der Durchführung dieser Funktionen diejenige Frequenz festzustellen, bei der der Stromverbrauch den zulässigen Maximalwert nicht überschreitet. Die so ermittelte Frequenz wird sodann als maximale Betriebsfrequenz der Schaltungsanordnung angegeben. Bei anderen Funktionen der Schaltungsanordnung wäre jedoch eine höhere Frequenz und somit ein insgesamt besseres Leistungsverhalten möglich, ohne daß dabei der maximal erlaubte Stromverbrauch überschritten werden würde.

Dokument US-A-5 974 557 offenbart eine Frequenzregelschaltung zur thermischen Kontrolle einer Schaltungsanordnung, die in Abhängigkeit von der gemessenen Temperatur desen Arbeitsfrequenz derart verringert, dass eine Überhitzung der Schaltungsanordnung infolge hoher Verarbeitungsaktivität vermieden wird.

Dokument JP 10240373 A offenbart eine Stromversorgungseinrichtung für einen Mikroprozessor, die dessen momentane Aktivität anhand des von ihm aufgenommenen Stromes bestimmt. Unterschreitet der aufgenommene Strom einen vorbestimmten Schwellwert, so wird der Arbeitstakt des Prozessors auf eine geringere, festgelegte Taktfrequenz als die normale Arbeitsfrequenz eingestellt.

Aufgabe der Erfindung ist es daher, eine Frequenzregelschaltung anzugeben, die eine möglichst hohe Leistung der Schaltungsanordnung durch Ausnutzen der maximal möglichen Frequenz ermöglicht, ohne daß dabei die Schaltungsanordnung unzulässig stark erwärmt wird. Diese Aufgabe wird gemäß der Erfindung durch eine Frequenzregelschaltung zur stromverbrauchsabhängigen Taktversorgung einer Schaltungsanordnung gelöst mit einer Strommeßvorrichtung zur Messung der momentanen Stromaufnahme der Schaltungsanordnung, einer steuerbaren Taktversorgungsschaltung, die mit einem Taktsignaleingang der Schaltungsanordnung verbindbar ist und einer Steuervorrichtung zur Ansteuerung der Taktversorgungsschaltung aufgrund der gemessenen Stromaufnahme, wobei eine Erhöhung der Stromaufnahme der Schaltungsanordnung eine Reduzierung der Taktfrequenz am Ausgang der Taktversorgungsschaltung bewirkt.

Die Schaltung mißt also den momentanen Stromverbrauch und steuert aufgrund dessen die Frequenz des Taktsignals, mit der die Schaltungsanordnung versorgt wird. Dadurch ist gewährleistet, daß die Schaltungsanordnung immer mit der maximalen Leistung arbeitet, die bei Beachtung der zulässigen Maximalwerte für die Stromaufnahme möglich ist. Es steht also immer die maximal mögliche Leistung zur Verfügung, ohne daß die Schaltungsanordnung durch eine zu starke Erwärmung gefährdet ist.

In einer vorteilhaften Ausgestaltung der Taktversorgungsschaltung besitzt diese einen Taktgenerator, der ein Taktsignal mit einer konstanten Frequenz bereitstellt. Mit dem Taktgenerator ist ein Impulsfilter verbunden, wobei dieser von der Steuervorrichtung ansteuerbar ist. Zur Reduzierung der an die Schaltungsanordnung abzugebende Taktfrequenz werden aus dem durch den Taktgenerator zur Verfügung gestellten Taktsignal einzelne Impulse durch den Impulsfilter ausgefiltert bzw. unterdrückt.

Die Erfindung wird nachfolgend anhand eines Ausführungsbeispiels näher erläutert. Es zeigt:
Figur 1 eine Frequenzregelschaltung gemäß der Erfindung in einer Blockdarstellung und
Figur 2 eine detailliertere Darstellung der Taktversorgungsschaltung.

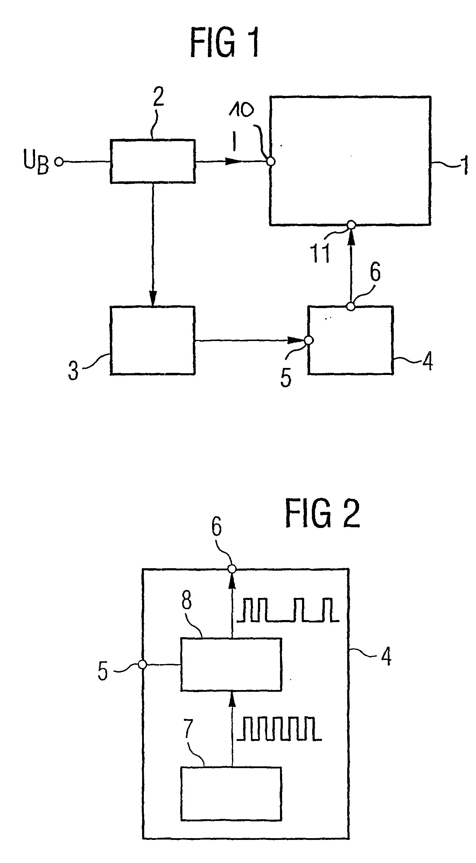

In Figur 1 ist eine erfindungsgemäße Frequenzregelschaltung in einem Blockschaltbild dargestellt. Eine Schaltungsanordnung 1 weist einen Spannungsversorgungseingang 10 und einen Takteingang 11 auf. Der Spannungsversorgungseingang 10 ist mit einer Betriebsspannung U_{B} verbunden. Ein Strom I, der von der Schaltungsanordnung 1 aufgenommen wird, wird durch eine Strommeßvorrichtung 2 gemessen. Eine Steuervorrichtung 3 setzt das Meßergebnis der Strommeßvorrichtung 2 in ein Steuersignal für eine Taktversorgungsschaltung 4 um. Dazu ist die Steuervorrichtung mit einem Steuereingang 5 der Taktversorgungsschaltung 4 verbunden. Ein Taktausgang 6 der Taktversorgungsschaltung 4 ist wiederum mit dem Takteingang 11 der Schaltungsanordnung 1 verbunden.

Bei der Durchführung von Rechenoperationen in der Schaltungsanordnung 1, die einen hohen Strombedarf haben, wird dies von der Strommeßvorrichtung 2 erfaßt und, sofern sich dadurch eine Überschreitung des maximal zulässigen Stroms ergibt, steuert die Steuervorrichtung 3 die Taktversorgungsschaltung 4 derart an, daß sich die Taktfrequenz, die der Schaltungsanordnung 1 zur Verfügung gestellt wird, reduziert. Durch die Reduzierung der Taktfrequenz, mit der die Schaltungsanordnung 1 arbeitet, reduziert sich auch deren Stromverbrauch, was durch die Meßvorrichtung 2 erfaßt wird. Infolge dessen wird die durch die Taktversorgungsschaltung bereitgestellte Taktfrequenz wieder erhöht, so daß jederzeit eine maximal mögliche Taktfrequenz zur Verfügung gestellt wird.

Eine detailliertere Darstellung der Taktversorgungsschaltung ist in Figur 2 dargestellt. Demnach besitzt die Taktversorgungsschaltung einen Taktgenerator 7, der eine konstante maximale interne Frequenz erzeugt. Außerdem besitzt sie ein Impulsfilter 8, das mit dem Steuereingang 5 und dem Taktausgang 6 verbunden ist. Zur Reduzierung der Taktfrequenz, wie anhand von Figur 1 beschrieben, werden einzelne Impulse des von dem Taktgenerator 7 erzeugten Taktsignals unterdrückt, was insgesamt zu einer Reduzierung der Taktfrequenz führt.

## Patentansprüche

1. Frequenzregelschaltung zur stromverbrauchsabhängigen Taktversorgung einer Schaltungsanordnung mit
- einer Strommeßvorrichtung (2) zur Messung der momentanen Stromaufnahme der Schaltungsanordnung (1) und
- einer steuerbaren Taktversorgungsschaltung (4), die einen Taktgenerator (7) aufweist und die mit einem Takteingang (11) der Schaltungsanordnung (1) verbindbar ist,
**gekennzeichnet durch**
- eine Steuervorrichtung (3) zur Ansteuerung der Taktversorgungsschaltung (4) aufgrund der gemessenen Stromaufnahme, wobei eine Erhöhung der Stromaufnahme der Schaltungsanordnung (1) ein Ausfiltern einzelner Taktpulse eines von dem Taktgenerator (7) erzeugten Taktsignals zur Reduzierung der Taktfrequenz am Ausgang (6) der Taktversorgungsschaltung bewirkt.

2. Frequenzregelschaltung nach Anspruch 1,
**dadurch gekennzeichnet, daß** der von der Strommeßvorrichtung (2) gemessene Strom durch Vergleichsmittel mit einem festlegbaren Schwellwert verglichen wird.

## Claims

1. Frequency regulating circuit for the current-consumption-dependent clock supply of a circuit arrangement having
- a current measuring device (2) for measuring the instantaneous current consumption of the circuit arrangement (1) and
- a controllable clock supply circuit (4), which has a clock generator (7) and can be connected to a clock input (11) of the circuit arrangement (1),
**characterized by**
- a control device (3) for driving the clock supply circuit (4) on the basis of the measured current consumption, an increase in the current consumption of the circuit arrangement (1) filtering out individual clock pulses of a clock signal generated by the clock generator (7) for reducing the clock frequency at the output (6) of the clock supply circuit.

2. Frequency regulating circuit according to Claim 1, **characterized in that** the current measured by the current measuring device (2) is compared with a definable threshold value by comparison means.

## Revendications

1. Circuit régulateur de fréquence qui est destiné à fournir à un circuit une horloge dépendante de la consommation de courant et qui comporte
- un dispositif de mesure de courant (2) pour mesurer la consommation de courant momentanée du circuit (1), et
- un circuit de fourniture d'horloge (4) commandable qui comporte un générateur d'horloge (7) et qui peut être relié à une entrée d'horloge (11) du circuit (1),
**caractérisé par**
- un dispositif de commande (3) pour commander le circuit de fourniture d'horloge (4) en fonction de la consommation de courant mesurée, une augmentation de la consommation de courant du circuit (1) provoquant alors une élimination par filtrage de certaines impulsions d'horloge d'un signal d'horloge produit par le générateur d'horloge (7) en vue de la réduction de la fréquence d'horloge à la sortie (6) du circuit de fourniture d'horloge.

2. Circuit régulateur de fréquence selon la revendication 1,
**caractérisé par le fait que** le courant mesuré par le dispositif de mesure de courant (2) est comparé par des moyens de comparaison à une valeur de seuil pouvant être fixée.
